# EUROPÄISCHE PATENTANMELDUNG

(11) **EP 1 033 762 A2**
(43) Veröffentlichungstag der Anmeldung: **06.09.2000**
(21) Anmeldenummer: 00104458.5
(22) Anmeldetag: 06.03.2000
(51) Int. Cl.: H01L 31/0392, H01L 31/0384, H01L 31/0352

(54) **Aus Fasern aufgebauter Sonnenkollektor**

(30) Priorität: 04.03.1999 DE 19909417
(71) Anmelder: Baumgärtner, Manfred, Dr., 70569 Stuttgart (DE); Schmid-Baumgärtner, Beate, 70569 Stuttgart (DE)
(72) Erfinder: Baumgärtner, Manfred, Dr., 70569 Stuttgart (DE); Schmid-Baumgärtner, Beate, 70569 Stuttgart (DE)
(74) Vertreter: Schwabe - Sandmair - Marx

(57) **Zusammenfassung**

Ein Sonnenkollektor weist Fasern auf oder besteht aus Fasern, die Trägerfasern für photovoltaisch aktives Material bilden. Die Fasern sind hohl oder porös. Die Hohlfasern sind an Innenseiten mit dem photovoltaisch aktiven Material beschichtet. Die porösen Fasern sind mit dem photovoltaisch aktiven Material imprägniert.

## Beschreibung

Die Erfindung betrifft einen Sonnenkollektor, der mit Hilfe von Fasern gebildet ist oder aus Fasern besteht, die Trägerfasern für ein photovoltaisch aktives Material bilden.

Aus Solarzellen aufgebaute Sonnenkollektoren wurden bislang in Form von Platten gefertigt. Dabei dient eine Glasplatte als Träger, auf den die stromerzeugenden aktiven Schichten aufgebracht sind. Als Träger werden auch Folien eingesetzt.

Die bisherigen Systeme haben Nachteile:
1. Durch die flächenhafte Aufbringung der aktiven Schichten werden hochpräzise in der Fläche arbeitende und somit teure Verfahren benötigt, z.B. zur Herstellung von mono- oder polykristallinen Siliziumscheiben oder zur Aufbringung ultradünner Schichten von III-IV-Halbleitern und deren Bearbeitung, z.B. mittels Laserschneiden.
2. Selbst die modernen Folienkollektoren benötigen noch eine definierte und plane Oberfläche, so dass beispielsweise eine Klebeverbindung möglich gemacht werden kann. Steife Träger erfordern eine Rahmenanbringung.

Durch diese Einschränkungen ist der Preis der Systeme relativ hoch. Eine großflächige Nutzung existierender Oberflächen scheidet zudem aufgrund der unter 2. genannten Anforderungen in vielen Fällen aus. Damit sind einer großflächigen Verbreitung und somit einem maßgeblichen Beitrag der Photovoltaik zum Strommix immer noch enge Grenzen gesetzt.

Eine Lösung können Faserkollektoren bieten. Die Fasern dienen als Träger für das photovoltaisch aktive Material. Aus flexiblen Trägerfasern aufgebaute Flächengebilde, insbesondere Fasergewebe oder auf flexiblen Trägerschichten angebrachte Faserflächengebilde, können in eine nahezu beliebige Form gebracht werden.

Aus dem Stand der Technik bekannte Faserkollektoren sind aus Fasern gebildet, die mit photovoltaisch aktivem Material ummantelt sind. Lediglich beispielhaft wird für den Stand der Technik auf die JP 59-144177, die DE 43 36 825 A1, die DE 43 36 582 A1, die WO 84/04425 und die JP 60-42876 verwiesen, aus denen solche Faserkollektoren hervorgehen.

Eine Aufgabe der Erfindung ist es, einen Sonnenkollektor mit Faserstruktur zu schaffen, der mechanisch belastbar ist und eine lange Lebensdauer aufweist.

Diese Aufgabe wird durch die Gegenstände der unabhängigen Ansprüche gelöst. Bevorzugte Ausgestaltungen werden in den Unteransprüchen beschrieben. Die in den Unteransprüchen beschriebenen Merkmale und die in bevorzugter Kombination in der nachfolgenden Beschreibung offenbarten Merkmale bilden die Gegenstände der unabhängigen Ansprüchen in den offenbarten Kombinationen und auch je einzeln weiter.

Ein erfindungsgemäßer Faserkollektor umfasst oder besteht aus Hohlfasern oder porösen Fasern, die als Einzelfasern auch im Falle von porösen Fasern vorzugsweise flexibel bzw. gut biegbar sind. Im Falle von Hohlfasern sind die hohlen Fasern mit dem photovoltaisch aktiven Material innen beschichtet. Das photovoltaisch aktive Material kann einschichtig oder vorzugsweise in radialer Richtung mehrschichtig aufgetragen sein. Bei einem mehrschichtigen Materialauftrag wird zwischen zwei Schichten aus photovoltaisch aktivem Material ein p-n-Übergang gebildet. Die Hohlfasern sind vorzugsweise elektrische Isolatoren. Sie sind transparent, vorzugsweise über ihre gesamte Mantelfläche.

Die porösen Fasern weisen eine offene Porosität oder eine geschlossene Porosität oder eine Mischform aus offener und geschlossener Porosität auf, in die das photovoltaisch aktive Material bei einem Imprägnieren eindringt. Das photovoltaisch aktive Material in den Poren bildet große photovoltaisch aktive Flächen. In den Poren ist das photovoltaisch aktive Material gegen äußere mechanische Belastungen, beispielsweise gegen Schlagbelastung und Kratzen, geschützt. Die porösen Fasern sind vorteilhafterweise wenigstens halbtransparent. Bevorzugt sind sie transparent. Vorzugsweise sind sie elektrisch leitend, so dass die porösen Fasern selbst Elektroden des erfindungsgemäßen Kollektors bilden können. Automatisch werden hierdurch große Kontaktflächen zwischen der Elektrode und dem photovoltaisch aktiven Material in den Poren gebildet. Eine Gegenelektrode ist als äußere Beschichtung ausgebildet. Die Gegenelektrode wird vorzugsweise mit einer elektrischen Isolation überzogen. Anstatt einer äußeren Gegenelektrode kann eine poröse Faser, die mit einem p-dotierten Halbleitermaterial imprägniert ist, auch in unmittelbarem Kontakt mit einer anderen porösen Faser oder mehreren anderen porösen Fasern stehen, die mit einem n-dotierten Halbleitermaterial imprägniert ist bzw. sind, um auf diese Weise einen p-n-Übergang zwischen einander kontaktierenden Fasern zu erhalten, wobei allerdings ein Kurzschluss zwischen den Fasern zu vermeiden ist. Die beiden sich kontaktierenden porösen Fasern bilden in diesem Falle unmittelbar die Elektrode und die Gegenelektrode.

Ein erfindungsgemäßer Sonnenkollektor kann auch mit einem Vlies als poröses Trägermaterial gebildet werden. Die Einzelfasern des Vlieses können in sich wiederum porös sein. Es kann jedoch auch jedes andere Fasermaterial, das für die Herstellung von Vliesen geeignet bzw. üblicherweise verwendet wird, benutzt werden. Es wird in dieser Ausführungsform der Erfindung nicht je Einzelfaser, sondern das gesamte Vlies mit dem photovoltaisch aktivem Material imprägniert bzw. getränkt. Um die vorteilhafte Flexibilität eines Vlieses beizubehalten, kann oder können dem auf- oder einzubringenden Material ein oder mehrere Mediatoren, insbesondere Weichmacher wie Phtalsäureesther, zugegeben werden.

Die photovoltaisch wirksamen Schichten werden bei einem erfindungsgemäßen Faserkollektor auf Fasern aufgebracht. Generell können alle natürlich vorkommenden oder künstlich herzustellenden Fasern genutzt werden, z.B.:
1. Glasfasern,
2. Steinwollefasern,
3. Kunstfasern jeglicher Art, z.B. aus dem Textilbereich,
4. Naturfaser, z.B. Baumwolle, Sisal, Hanf etc.

Die Fasern können einen runden, insbesondere konzentrischen oder ellipsoiden, und/oder abgeflachten oder scheibenförmigen Querschnitt haben.

Aus heutiger technologischer Sicht erscheinen Glasfasern, insbesondere als Hohlfasermaterial, aufgrund ihrer thermischen Stabilität besonders geeignet. Auf die Fasern werden die photovoltaisch wirksamen Schichten in geeigneter Weise aufgebracht. Bei einer Innenbeschichtung wird vorzugsweise wie folgt verfahren:
1. Die Glasfaser wird nach dem Spinnvorgang, insbesondere Extrusion, direkt oder nach Vorbehandlung der Oberfläche beschichtet.
2. Bei Beschichtung mit n- oder p- dotierten Halbleitern wird so vorgegangen, dass eine Elektrode in Form einer ersten Kontaktschicht direkt auf die Glasfaser aufgebracht wird. Vorzugsweise wird der gesamte Faserquerschnitt ausgekleidet. Darüber wird konzentrisch der Absorber in Form wenigstens einer Absorptionsschicht aufgebracht. Auf den Absorber folgt optional eine Anpassungsschicht und darauf vorzugsweise eine zweite Kontaktschicht als Gegenelektrode. Die zweite Kontaktschicht füllt den verbliebenen Hohlquerschnitt vorzugsweise aus.
3. Bei Beschichtung mit kristallinen Silizium-Dünnschichten werden die jeweils notwendigen Schichten aufeinander abgeschieden.
4. Die Aufbringung erfolgt vorzugsweise schichtweise sukzessive und an abgelängten Faserstücken. Die jeweils geeigneten Verfahren der Aufbringung werden zum Einsatz gebracht, z.B. chemische Bad-Abscheidung, Galvanik, Elektrodeposition, Dünnschicht-Kristallisation. Die Faserstücke können senkrecht nebeneinander hängend in Längen von beispielsweise 1 m mit ihren Enden in ein Bad des jeweiligen Beschichtungsmaterials eingetaucht werden. Das Beschichtungsmaterial wird bevorzugt durch kapillaren Hub und besonders bevorzugt unterstützt durch aktives Saugen in die Hohlfasern gesaugt. Die Abscheidung an den Innenmantelflächen der Hohlfasern erfolgt vorzugsweise ebenso wie das Einziehen der Flüssigkeit temperaturkontrolliert. Vorzugsweise werden die Hohlfasern aktiv abgesaugt, sobald die Flüssigkeit mit dem jeweiligen Beschichtungsmaterial in die gesamte Hohlfaser eingesogen worden ist.
5. Alle Schichten können mit Mediatoren, beispielsweise Phtalsäureesther versehen werden, die eine Verbiegbarkeit bzw. Elastizität und andere wünschenswerte Eigenschaften, z.B. bezüglich Ausdehnungskoeffizienten, Alterungsbeständigkeit, Abriebfestigkeit etc. verbessern oder ermöglichen.

Bei Imprägnierung von porösen Fasern können in unterschiedlichem Maße definiert eine oder mehrere Schichten imprägniert werden. Eine Imprägnierung wird vorzugsweise in einem Badverfahren oder Bedampfungsverfahren durchgeführt. Bei einem bevorzugten Bedampfungsverfahren wird wie folgt vorgegangen:
1. Poröse Fasern werden oberflächlich mit einem geeigneten ersten photovoltaisch aktiven Material bedampft. Die Bedampfung erfolgt undefiniert über die gesamte Oberfläche der Fasern. Dabei werden insbesondere die Oberflächen der Poren beschichtet.
2. Anschließend wird die Mantelfläche der Fasern gereinigt, so dass das erste photovoltaisch aktive Material nur in den Poren verbleibt.
3. Danach wird ein anderes, zweites photovoltaisch aktive Material in einem weiteren Bedampfungsschritt undefiniert auf die gesamte Faseroberfläche aufgedampft, wobei die Poren der Fasern vorzugsweise vollkommen ausgefüllt werden.
4. Nun wird die Fasermantelfläche wieder gereinigt, so dass photovoltaisch aktives Material nur in den Poren verbleibt.
5. Nach der Reinigung werden die Fasern mit einem nichtleitenden Material ummantelt, das an dem Fasermaterial anhaftet. Es wird ein Trennmaterial bzw. Isoliermaterial verwendet, das an dem photovoltaisch aktiven Material nicht oder wesentlich schwächer anhaftet als dem Fasermaterial.
6. Gegebenenfalls wird ein weiterer Reinigungsschritt durchgeführt, bei dem das Trennmittel von dem photovoltaisch aktiven Material entfernt wird.
7. In einem weiteren Bedampfungsschritt wird die Gegenelektrode vollflächig auf die äußere Mantelfläche mit dem Isoliermaterial beschichteten Faser aufgedampft und dadurch in den freiliegenden Bereichen mit dem photovoltaisch aktiven Material elektrisch leitend verbunden. Als Material für die Gegenelektrode kommt insbesondere ein halbtransparenter oder transparenter, elektrisch leitender Kunststoff in Frage.

Bei einem Badverfahren kann in analoger Weise ebenso verfahren werden.

Eine für die erfindungsgemäßen Zwecke geeignete poröse Faser weist typischerweise einen Durchmesser auf, der im Bereich zwischen 100 und 200 µm liegt. Grundsätzlich sind jedoch auch andere Faserstärken geeignet. Die Porosität ist vorzugsweise derart, dass in den Fasern Hohlräume mit einem Durchmesser von vorzugsweise wenigstens 10 µm in großer Zahl vorliegen. Ein bevorzugtes Fasermaterial ist ein transparenter oder halbtransparenter elektrisch leitender Kunststoff. Die Porosität kann bei solch einem Material durch Zumischung geeigneter Zuschlagsstoffe unmittelbar bei der Herstellung, beispielsweise einer Extrusion, erzielt werden oder im Wege einer Nachbehandlung, vorzugsweise durch eine Temperatur-Schockbehandlung, insbesondere Schockgefrierung. Geeignete Verfahren sind beispielsweise aus der Bekleidungsindustrie bekannt, wo nach der Herstellung zunächst noch "dichte" Fasern durch eine thermische Behandlung mit Warm/Kalt-Wechselzyklen porös gemacht werden, um saugfähige Fasern zu erhalten.

Die Kontaktierung erfolgt durch geeignete Methoden, z.B.:
1. Die Faser wird vorzugsweise an ihrer gesamten Außenmantelfläche imprägniert oder ihrer gesamten Innenmantelfläche mit den notwendigen Schichten beschichtet.
2. Vorzugsweise werden in gewissen Abschnitten, z.B. am Anfang, am Ende oder dazwischen, Fenster bis auf die Elektrode oder die Gegenelektrode geätzt.
3. In gewissen Abschnitten kann bei porösen Fasern auch die Gegenelektrode ausgespart werden.
4. Im Falle der Herstellung von Textilien erfolgt eine Verschaltung bevorzugt durch spezielle Querfasern (Schuß) aus leitenden Materialien, z.B. Kupfer. Beispielsweise liegen die Fasern längs nebeneinander mit offenen Elektrodenbereichen, d.h. frei zugänglich, auf einer Seite. Auf dieser Seite verlaufende leitende Querfasern kontakten die Elektroden der einzelnen Fasern. In einem anderen Bereich verlaufende leitende Querfasern kontakten die dort freiliegenden Gegenelektrodenbereiche auf gleiche Weise.
5. Die freiliegenden Elektroden und/oder Gegenelektroden können im Bereich der Kontaktierung verstärkt werden, z.B. durch Leiter wie Kupfer, Gold oder elektrisch leitende Kunststoffe. Diese erscheinen besonders günstig, da sie neben der Kontaktierung noch eine Schutzfunktion ausüben können.
6. Auf die beschriebene Weise können durch geeignete Webemuster mit den Einzelfaserkollektoren und leitenden Kontaktfasern auch komplexe Reihen- und Parallelschaltungen verwirklicht werden. Dazu werden beispielsweise versetzt liegende Kontaktfenster der parallel liegenden Einzelfaserkollektoren über leitende Querfasern elektrisch leitend miteinander verbunden.
7. Durch den Einbau faserförmiger elektronischer Bauteile wie z.B. Sensoren oder IC's können sogar 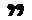 intelligente" oder sich selbst steuernde Einheiten erzeugt werden. Entsprechende elektronische Bauteile können bei Verwendung von Hohlfasern auch in den Hohlfasern angeordnet werden.
8. Die Ab- oder Zuleitung von Strom- und Steuersignalen erfolgt bevorzugt über geeignete Steckverbindungen oder durch Vernähen oder Verlöten der ableitenden Kontaktfasern.

Neben Einzelfaserkollektoren und leitenden Fasern können in unterschiedlichen Anteilen auch andere Fasern unterschiedlicher Funktion mit verwoben werden, z.B. als Stützfasern, transparente Fasern, Natur- und Kunstfasern, um z.B. 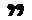 Atmungsaktivität" oder Wasserdampfdurchlässigkeit bei einem Faserkollektorflächengebildes zu erhalten.

Die Verarbeitung der innen beschichteten oder imprägnierten Einzelfaserkollektoren erfolgt in geeigneter Weise, beispielsweise nach folgendem Verfahren:
1. Die Fasern werden einzeln mit einer dünnen transparenten Schutzschicht überzogen, beispielsweise aus Kunst- oder Naturlack. Die Fasern werden dann mit sich selbst oder mit nicht photovoltaisch aktiven Fasern zu Faserstrukturen, insbesondere Textilien, Matten oder Netzen, verwoben. Dabei kann auch zwei- und mehrlagig mit Trägertextil kombiniert werden. Matten aus den Fasern können wie Textilien weiterverarbeitet werden.
2. Die Fasern werden mit transparentem Füllmaterial, z.B. Kunstharz zu faserverstärkten Baumaterialien oder in Verbindung mit anderen Materialien, beispielsweise Blech, Holz und/oder Kunststoffen, zu Verbundwerkstoffen beliebiger Form weiterverarbeitet. Auch verwobene Fasern können auf diese Weise weiterverarbeitet werden.
3. Die Fasern werden als Haufwerk oder in anderen ungewobener Form verwendet.

Größere Flächenstrukturen können beispielsweise durch Zusammennähen, Zusammenkleben, Verschweißen oder mittels Reisverschlüssen aus mehreren kleineren Flächenstrukturen gebildet werden.

Durch die Herstellung von erfindungsgemäßen Faserflächengebilden bzw. -strukturen besteht die Möglichkeit, weitgehend einschränkungslos Oberflächen mit Sonnenkollektoren zu überziehen oder entsprechende Bauteile zu formen. Dadurch wird es ermöglicht, ohne weitere Oberflächenanforderungen oder Trägerbauten existierende Massenflächen zu nutzen. Als erfindungsgemäße Verwendungsbeispiele seien genannt:
1. Dächer: Dachziegel können bei der Produktion oder auf dem Dach ausgestattet werden. Erfindungsgemäße Matten werden beispielsweise mit transparentem Kleber der jeweiligen Oberflächenform angepaßt aufgeklebt und versiegelt.
2. Fassaden: Existierende oder neue Fassaden beliebiger Rauhigkeit, beispielsweise moderne vorgehängte Fassaden, Rauhputz, Holzhäuser oder Strohmatten, können mittels eines vorzugsweise transparenten Klebeanstrichs oder durch Verspannen mit den Textilien, Matten oder Netzen versehen werden.
3. Fels und Erde: Durch Auslegen und Verspannen der Matten, z.B. mit Pflöcken, kann unproduktives Gelände genutzt werden. Sanddünen können eingehüllt und so am Wandern gehindert werden.
4. Bäume: Über Schattenbäume können Sonnenkollektoren in Form von teiltransparenten Netzen gespannt werden. Das Baumwachstum unter den Netzen wird nicht gestört. Gleichzeitig wird ein Verdunstungsschutz geschaffen, was in entsprechenden Klimaten für Pflanzenanlagen günstig sein kann.
5. Verkehrswege: Anbringung unterhalb transparenter Schutzschichten.

Es wird deutlich, dass die Erfindung es ermöglicht, weitgehend alle geeigneten Oberflächen des menschlichen Umfeldes sowie der belebten oder unbelebten Natur zur Stromerzeugung zu nutzen.

## Patentansprüche

1. Sonnenkollektor mit Fasern, die mit wenigstens einem photovoltaisch aktiven Material beschichtet sind,
**dadurch gekennzeichnet**, dass
a) die Fasern hohl sind und
b) das photovoltaisch aktive Material an Innenseiten der Fasern aufgetragen ist.

2. Sonnenkollektor nach dem der vorherigen Anspruch, dadurch gekennzeichnet, dass in den Fasern je wenigstens ein Fenster gebildet ist, vorzugsweise durch Ätzen, und dass durch das wenigstens eine Fenster hindurch eine Schicht des photovoltaisch aktiven Materials elektrisch leitend kontaktiert ist.

3. Sonnenkollektor nach einem der vorherigen Ansprüche, dadurch gekennzeichnet,
dass die Fasern mit dotierten Halbleitern beschichtet sind,
eine als Elektrode dienende, elektrisch leitende erste Kontaktschicht direkt auf den Fasern,
auf der ersten Kontaktschicht wenigstens eine Absorptionsschicht
und auf der wenigstens einen Absorptionsschicht eine Gegenelektrode aufgebracht sind,
wobei die erste Kontaktschicht oder die zweite Kontaktschicht oder beide Kontaktschichten transparent sind
und wobei zwischen der ersten Kontaktschicht und der angrenzenden, wenigstens einen Absorptionsschicht vorzugsweise eine Anpassungsschicht vorgesehen ist.

4. Sonnenkollektor mit Fasern, die Trägerfasern für photovoltaisch aktives Material bilden,
**dadurch gekennzeichnet,** dass
a) die Fasern porös und
b) mit dem photovoltaisch aktiven Material imprägniert sind.

5. Sonnenkollektor nach dem vorherigen Anspruch, dadurch gekennzeichnet, dass die porösen Fasern je sukzessiv mit mehreren photovoltaisch aktiven Materialschichten imprägniert sind, wobei zwischen zwei Schichten des photovoltaisch aktiven Materials ein p-n-Übergang gebildet ist.

6. Sonnenkollektor nach einem der vorherigen Ansprüche, dadurch gekennzeichnet, dass die Fasern transparent sind.

7. Sonnenkollektor nach einem der vorherigen Ansprüche, dadurch gekennzeichnet, dass das photovoltaisch aktive Material und/oder ein weiteres Beschichtungsmaterial mit wenigstens einem Mediator versehen ist, der eine Verbiegesteifigkeit der Fasern des Sonnenkollektors verringert.

8. Sonnenkollektor nach einem der vorherigen Ansprüche, dadurch gekennzeichnet, dass die Fasern aus einem Material bestehen, das Glas, Steinwolle oder Kunststoff ist oder umfasst.

9. Sonnenkollektor nach einem der vorherigen Ansprüche, dadurch gekennzeichnet, dass in den Sonnenkollektor elektronische Bauteile, insbesondere Sensoren und/oder integrierte Schaltungen (IC's), integriert sind, wobei die elektronischen Bauteile vorzugsweise faserförmig sind.

10. Sonnenkollektor nach einem der vorherigen Ansprüche, dadurch gekennzeichnet, dass sich die Fasern dicht oder beabstandet längs nebeneinander erstrecken mit freiliegenden Elektroden auf einer Seite und auf dieser Seite verlaufende, elektrisch leitende Querfasern die Elektroden der Fasern kontakten und in einem anderen Bereich oder mehreren anderen Bereichen verlaufende, elektrisch leitende Querfasern die Gegenelektroden der Fasern kontakten.

11. Sonnenkollektor nach einem der vorherigen Ansprüche, dadurch gekennzeichnet, dass die Elektroden und/oder die Gegenelektroden in einem Bereich einer Kontaktierung durch elektrische Leiter wie Kupfer, Gold oder leitende Kunststoffe, verstärkt sind.

12. Sonnenkollektor nach einem der vorherigen Ansprüche, dadurch gekennzeichnet, dass durch Verweben der Fasern mit elektrisch leitenden Kontaktfasern Reihenschaltungen und/oder Parallelschaltungen gebildet werden, wobei versetzt in den Fasern freiliegende Elektroden und Gegenelektroden der parallel liegenden Fasern über die quer zu den Fasern sich erstreckenden Kontaktfasern kontaktet werden.

13. Sonnenkollektor nach einem der vorherigen Ansprüche, dadurch gekennzeichnet, dass die Fasern mit Naturfasern und/oder Kunstfasern zu einem für Wasserdampf durchlässigen Gewebe verwoben sind.

14. Sonnenkollektor nach einem der vorherigen Ansprüche, dadurch gekennzeichnet, dass die Fasern mit sich selbst und vorzugsweise mit nicht photovoltaisch aktiven Fasern zu Textilien, Matten oder Netzen verwoben sind.

15. Sonnenkollektor nach dem vorherigen Anspruch, dadurch gekennzeichnet, dass die Textilien, Matten oder Netze zwei- oder mehrlagig mit einem Trägertextilgewebe kombiniert sind.

16. Sonnenkollektor nach einem der zwei vorherigen Ansprüche, dadurch gekennzeichnet, dass die Textilien, Matten oder Netze mit einer Unterlage aus Metall, Holz oder Kunststoff zu einem Schichtverbundwerkstoff verbunden sind.
